# EUROPÄISCHE PATENTSCHRIFT

(11) **EP 1 354 320 B1**
(45) Veröffentlichungstag und Bekanntmachung des Hinweises auf die Patenterteilung: **08.09.2004**
(21) Anmeldenummer: 02701202.0
(22) Anmeldetag: 18.01.2002
(51) Int. Cl.: G11C 11/16

(54) **AUSWAHLEINRICHTUNG FÜR EINE HALBLEITERSPEICHEREINRICHTUNG**
SELECTION DEVICE FOR A SEMICONDUCTOR MEMORY DEVICE
DISPOSITIF SELECTEUR D'UN DISPOSITIF MEMOIRE A SEMICONDUCTEURS

(30) Priorität: 19.01.2001 DE 10102431
(43) Veröffentlichungstag der Anmeldung: 22.10.2003
(73) Patentinhaber: Infineon Technologies AG, 81669 München (DE)
(72) Erfinder: VIEHMANN, Hans-Heinrich, South Burlington, VT, 05403 (US)
(74) Vertreter: Kottmann, Heinz Dieter, Dipl.-Ing.
(86) Internationale Anmeldenummer: PCT/DE2002/000141
(87) Internationale Veröffentlichungsnummer: WO 2002/058070

(56) Entgegenhaltungen:
- US-A- 4 371 956
- US-A- 5 493 246
- US-A1- 2001 007 537

## Beschreibung

Die Erfindung betrifft eine Auswahleinrichtung für eine Halbleiterspeichereinrichtung oder dergleichen gemäß dem Oberbegriff des Anspruchs 1.

Moderne Halbleiterspeichereinrichtungen weisen einen Speicherbereich mit einer Mehrzahl von Speicherelementen oder Speicherzellen auf. Die Speicherelemente oder Speicherzellen sind dabei oft in einer matrixartigen Anordnung ausgebildet und über Zugriffsleitungseinrichtungen, zum Beispiel Bitleitungen und Wortleitungen, ansprechbar, um den Speicherzustand oder Informationszustand jedes Speicherelements oder jeder Speicherzelle auszulesen und/oder zu verändern.

Das Ansprechen oder die Adressierung und somit der Zugriff erfolgen dabei in der Regel über entsprechende Auswahleinrichtungen gemäß einer Zeilenauswahl, zum Beispiel für die Wortleitungen, sowie durch eine Spaltenauswahl, zum Beispiel für die Bitleitungen. Dabei bildet das System der matrixartig angeordneten Speicherzellen sowie der ausgewählten und der nicht ausgewählten Zugriffsleitungen ein Netzwerk Ohmscher Widerstände, wobei insbesondere die Zellenwiderstände der einzelnen Speicherelemente oder Speicherzellen zu berücksichtigen sind.

Durch die Auswahl einer entsprechenden Wortleitung und einer entsprechenden Bitleitung soll, insbesondere beim Lesen, genau eine wohldefinierte Speicherzelle oder ein wohldefiniertes Speicherelement angesprochen werden. Aufgrund der netzwerkartigen Verschaltung der Mehrzahl der Speicherzellen oder der Speicherelemente des Speicherbereichs treten aber neben dem den Speicherzustand der angesprochenen Zelle repräsentierenden Signal auch sogenannte parasitäre Signale aus den nicht ausgewählten Speicherelementen oder Speicherzellen und/oder den entsprechenden Zugriffsleitungen auf. Diese parasitären Signale überlagern sich dem eigentlich zu detektierenden und zu analysierenden Signal der selektierten Zelle und können zu Verfälschungen führen.

Zur Unterdrückung dieser parasitären Signale oder zur Reduzierung ihres Einflusses bedient man sich üblicherweise einer Leseverstärkereinrichtung, durch welche die Potenzialdifferenz über den nicht selektierten Speicherbereich und der damit im Zusammenhang stehende elektrische Strom möglichst klein, zumindest jedoch konstant, gehalten werden kann, so dass das zu detektierende Signal der selektierten Zelle, gerade bei MRAM-Zellen auf der Basis einer sogenannten Cross-Point-Anordnung, von den parasitären Signalen unterschieden werden kann.

Problematisch bei herkömmlichen Auswahleinrichtungen ist, dass unter realen Bedingungen beim Lesevorgang, insbesondere von MRAM-Zellen, der Lesestrom über die Mehrzahl nicht durchgeschalteter Schaltelemente, insbesondere in der Form von Transistoreinrichtungen oder dergleichen, zu Spannungsabfällen führt, so dass die Spannung oder das Potenzial der auszulesenden Zugriffsleitungseinrichtung oder Bitleitung durch den Leseverstärker nicht auf den korrekten Wert geregelt werden kann.

Aus US-A-4371956 ist eine Schalteinrichtung bekannt die vier Transistoren aufweist und wobei die Kompensationsschaltung das Potenzial einer Dummy-Bitleitung misst um das Potenzial der Bitteitung zu erhöhen.

Der Erfindung liegt die Aufgabe zugrunde, eine Auswahleinrichtung für eine Halbleiterspeichereinrichtung anzugeben, bei welcher Betriebsstörungen durch die durch Leseströme verursachte Spannungsabfälle auf besonders einfache Weise und gleichwohl zuverlässig vermieden werden können.

Die Aufgabe wird bei einer gattungsgemäßen Auswahleinrichtung erfindungsgemäß durch die kennzeichnenden Merkmale des Anspruchs 1 gelöst. Vorteilhafte Weiterbildungen der erfindungsgemäßen Auswahleinrichtung sind Gegenstand der abhängigen Unteransprüche.

Die gattungsgemäße Auswahleinrichtung für eine Halbleiterspeichereinrichtung oder dergleichen weist für jede auswählbare Zugriffsleitungseinrichtung, insbesondere für jede Bitleitungseinrichtung oder dergleichen, zum Zugriff auf Speicherelemente des Speicherbereichs der Halbleiterspeichereinrichtung, welche mit der jeweiligen auswählbaren Zugriffsleitungseinrichtung verbunden sind, jeweils eine zugeordnete Schalteinrichtung oder dergleichen auf. Dabei ist im Betrieb durch die Schalteinrichtung die jeweilige Zugriffsleitungseinrichtung bei Auswahl mit einer Leseverstärkereinrichtung steuerbar verbindbar, und zwar mit einem Potenzialabtastanschluss der Leseverstärkereinrichtung zum Erfassen des elektrischen Potenzials der jeweiligen Zugriffsleitungseinrichtung und mit einem Stromeinspeiseanschluss der Leseverstärkereinrichtung zum Einspeisen eines Kompensationsstroms in die jeweilige Zugriffsleitungseinrichtung.'

Bei der erfindungsgemäßen Auswahleinrichtung ist es vorgesehen, dass jede Schalteinrichtung jeweils ein erstes und ein zweites Schaltelement aufweist. Im Betrieb ist durch das erste Schaltelement die zugeordnete Zugriffsleitungseinrichtung mit dem Potenzialabtastanschluss der Leseverstärkereinrichtung verbindbar. Ferner ist im Betrieb durch das zweite Schaltelement die zugeordnete Zugriffsleitungseinrichtung mit dem Stromeinspeiseanschluss der Leseverstärkereinrichtung verbindbar.

Bei herkömmlichen Auswahleinrichtungen ist für jede auswählbare Zugriffsleitungseinrichtung, insbesondere Bitleitung oder dergleichen, im Wesentlichen ein einziges Schaltelement vorgesehen. Durch dieses einzige Schaltelement wird in herkömmlicher Weise die jeweils zugeordnete Zugriffsleitungseinrichtung insgesamt mit dem Potenzialabtastanschluss und gleichzeitig mit dem Stromeinspeiseanschluss der zugeordneten Leseverstärkereinrichtung verbunden. Bei der herkömmlichen Anordnung fließt im Betrieb im realen Anwendungsfall auch über die nicht durchgeschalteten Schaltelemente, z. B. über Schalttransistoren, ein gewisser Lesestrom, der zu einem nicht kontrollierbaren Spannungsabfall über die gesamte Auswahleinrichtung führt, welcher durch die Leseverstärkereinrichtung insgesamt nicht ausgeregelt werden kann. Folglich kann bei herkömmlichen Auswahleinrichtungen durch die angeschlossenen Leseverstärkereinrichtungen keine definierte Spannung am Ende der jeweiligen ausgewählten Bitleitungseinrichtungen aufrechterhalten werden.

Bei der erfindungsgemäßen Vorgehensweise dagegen sind zwei Schaltelemente vorgesehen, wobei das erste Schaltelement jeweils eine Verbindung zum Potenzialabtastanschluss und das zweite Schaltelement parallel dazu eine Verbindung zum Stromeinspeiseanschluss der Leseverstärkereinrichtung herstellen kann. Bei ausgewählter Zugriffsleitungseinrichtung, d.h. ausgewählter Bitleitung, ist das erste Schaltelement durchgeschaltet, und es ist ein Kontakt mit dem Potenzialabtastanschluss der Leseverstärkereinrichtung hergestellt. Da Potenzialabtastanschlüsse relativ hochohmig ausgebildet sind, fließt über das geschlossene erste Schaltelement im Wesentlichen kein Lesestrom, so dass die Größe des Widerstands des ersten Schaltelements und somit der darüber abfallende Spannungsabfall unerheblich sind. Der Potenzialabtastanschluss kann somit das am Ende der Zugriffsleitungseinrichtung, insbesondere der Bitleitungseinrichtung, vorliegende elektrische Potenzial exakt erfassen.

Durch das parallel dazu vorgesehene zweite Schaltelement, welches bei Auswahl ebenfalls durchgeschaltet oder geschlossen vorliegt, regelt die angeschlossene Leseverstärkereinrichtung über den entsprechenden Anschluss den Kompensationsstrom solange nach, bis die über das erste, geschlossene Schaltelement detektierte Potenzialdifferenz den korrekten Wert annimmt. Somit ist der Widerstand des zweiten Schaltelements ebenfalls nahezu ohne Bedeutung, weil dessen Einfluss von der Leseverstärkereinrichtung gerade ausgeregelt werden kann. Der von der Leseverstärkereinrichtung aufgebrachte Kompensationsstrom wird ausgewertet und spiegelt jeweils den ausgelesenen Programmierzustand der selektierten Speicherzelle oder des selektierten Speicherelements wider.

Die grundlegende Idee der vorliegenden Erfindung besteht also darin, bei der Auswahleinrichtung zwei Schaltelemente in Parallelschaltung zueinander zur Kontaktierung mit dem Potenzialabtastanschluss einerseits und dem Stromeinspeiseanschluss andererseits auszubilden, so dass die Spannungsabfälle über die Ohmschen Widerstände der Schaltelemente aufgrund des Regelmechanismus ausgeregelt werden können und keinerlei Bedeutung haben.

Dazu sind die vorgesehenen ersten und zweiten Schaltelemente jeweils im Wesentlichen parallel zueinander verschaltet ausgebildet.

Ferner ergibt sich ein besonders einfacher Betrieb der erfindungsgemäßen Auswahleinrichtung, wenn durch die Schaltelemente jeweils im Wesentlichen zwei Schaltzustände ausbildbar sind, insbesondere jeweils ein durchgeschalteter oder kontaktierender und ein nicht durchgeschalteter oder trennender Schaltzustand.

Eine besonders zuverlässige Regelung oder ein besonders geringer Einfluss der Ohmschen Widerstände der Schaltelemente ergibt sich, wenn durch das erste Schaltelement im ersten, durchgeschalteten oder kontaktierenden Zustand, ein vergleichsweise niederohmiger Kontakt herstellbar ist, insbesondere mit dem Potenzialanschluss der Leseverstärkereinrichtung.

Besonders einfach gestaltet sich die erfindungsgemäße Auswahleinrichtung dann, wenn die Schaltelemente als Transistoreinrichtungen ausgebildet sind, insbesondere als MOSFETs, oder dergleichen.

Dabei ist es bevorzugt vorgesehen, dass jeweils Drainbereiche der Transistoreinrichtungen mit der zugeordneten Zugriffsleitungseinrichtung verbunden ausgebildet sind. Ferner ist es vorgesehen, dass jeweils Sourcebereiche der Transistoreinrichtungen mit dem jeweiligen Potenzialabtastanschluss bzw. dem Stromeinspeiseanschluss der zugeordneten Leseverstärkereinrichtung verbunden ausgebildet sind.

Grundsätzlich kann jede Zugriffsleitungseinrichtung, insbesondere jede Bitleitungseinrichtung, jeweils einer separaten Leseverstärkereinrichtung zugeordnet sein, so dass durch jede Schalteinrichtung bei Auswahl der entsprechenden zugeordneten Zugriffsleitungseinrichtungen auch eine entsprechende Leseverstärkereinrichtung ausgewählt wird.

Andererseits ergibt sich ein besonders platzsparendes Konzept, wenn die Mehrzahl der Ausgangsanschlüsse, insbesondere der Sourcebereiche, der ersten und zweiten Schaltelemente jeweils mit einer gemeinsamen Leitungseinrichtung und über diese mit einer gemeinsamen Leseverstärkereinrichtung verbunden ist.

Das bedeutet insgesamt, dass eine Mehrzahl auswählbarer Zugriffsleitungseinrichtungen durch eine einzige, gemeinsame Leseverstärkereinrichtung auslesbar ist. Durch die gemeinsamen Leitungseinrichtungen werden dann zum einen die Ausgangsanschlüsse der ersten Schaltelemente gemeinsam mit dem einzigen Potenzialabtastanschluss der gemeinsamen Leseverstärkereinrichtung verbunden. Andererseits werden durch die zweite gemeinsame Leitungseinrichtung sämtliche Ausgangsanschlüsse der zweiten Schaltelemente mit dem gemeinsamen Stromeinspeiseanschluss des gemeinsamen Leseverstärkers verbunden. Es ist somit insgesamt für die so organisierte Gruppe von Speicherzellen oder auswählbaren Zugriffsleitungseinrichtungen insgesamt nur eine einzige Leseverstärkereinrichtung notwendig.

Nachfolgend wird die Erfindung anhand bevorzugter Ausführungsformen auf der Grundlage einer schematischen Zeichnung näher erläutert.
- Fig. 1: zeigt anhand eines schematischen Schaltungsdiagramms den grundlegenden Aufbau einer Speichereinrichtung unter Verbindung der erfindungsgemäßen Auswahleinrichtung.
- Fig. 2: zeigt anhand eines schematischen Schaltungsdiagramms Details der Verschaltung einer Ausführungsform der erfindungsgemäßen Auswahleinrichtung.

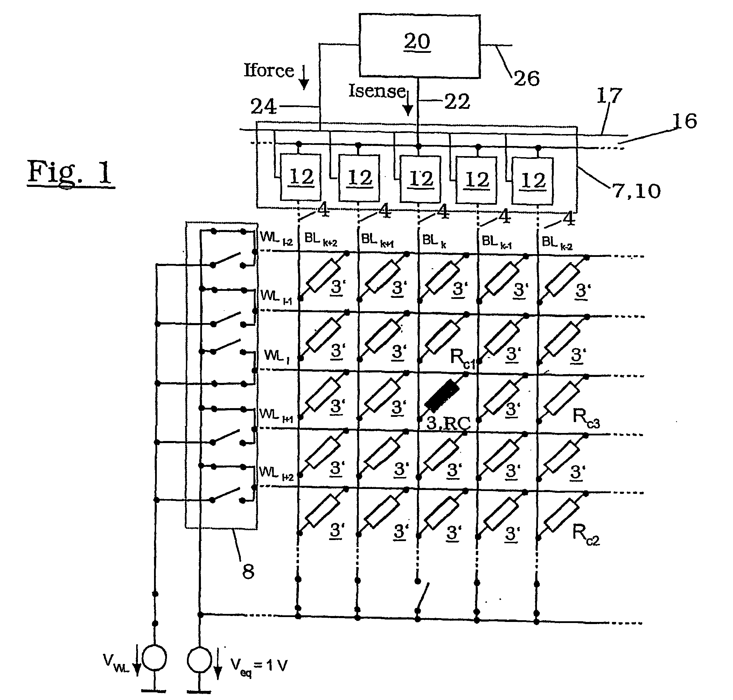

Fig. 1 zeigt in einer schematischen Schaltungsanordnung den grundsätzlichen Aufbau einer Halbleiterspeichereinrichtung 1 unter Verwendung einer Ausführungsform der erfindungsgemäßen Auswahleinrichtung 10.

Die Halbleiterspeichereinrichtung 1 weist einen Speicherbereich 2 auf. Dieser besteht aus einer matrixartigen Anordnung von Speicherzellen 3 und 3', wobei die Speicherzellen oder Speicherelemente 3' in dem in Fig. 1 gezeigten Zustand der Halbleiterspeichereinrichtung 1 nicht zum Auslesen selektiert sind. Dagegen ist das Speicherelement 3 des Speicherbereichs 2 zum Auslesen ausgewählt oder selektiert. Zu dieser Auswahl oder Selektion ist in Fig. 1 die Wortleitung WLi zusammen mit der Bitleitung BLk der Zugriffsleitungseinrichtungen 6 bzw. 4 durch entsprechende Schaltzustände der Zeilenselektoren oder -multiplexer 8 bzw. Spaltenselektoren oder -multiplexer 7 realisiert. Sowohl die Zeilenselektoren als auch die Spaltenselektoren 8 bzw. 7 können die erfindungsgemäß beschriebene Struktur aufweisen.

Die selektierte Wortleitung WLi liegt auf der Wortleitungsspannung oder Lesespannung Vwl. Sämtliche nicht selektierten Wortleitungen oder Bitleitungen der Zugriffsleitungseinrichtungen 6 und 4 liegen auf der Äquipotenzialspannung oder Ausgleichsspannung Veq. Im Idealfall liegt auch die selektierte Bitleitung BLk an ihrem Ende, nämlich am Knoten 7a und also am Potenzialabtastanschluss 22 der Leseverstärkeranordnung 20 auf der Äquipotenzialspannung Veq.

Fig. 1 gibt insbesondere die Beschaltung beim Auslesen einer Cross-Point-MRAM-Speichermatrix wider. Aus der Anordnung der Fig. 1 ergibt sich auch, dass durch die Ohmschen Widerstände RC1 und RC2 der entsprechenden Speicherzellen 3' keine parasitären Ströme fließen, welche das Lesesignal der selektierten Speicherzelle 3 mit ihrem Ohmschen Widerstand RC stören können. Auch die Ströme durch RC3 führen zu keiner wesentlichen Störung des Lesesignals.

Fig. 1 zeigt auch, dass durch den dargestellten Spaltenmultiplexer 7 oder die Auswahleinrichtung 10 für die Bitleitungen BLj jeweils eine bestimmte Bitleitung BLk der Speichereinrichtung 1 an den Eingang 22 der Leseverstärkereinrichtung 20 geschaltet werden kann.

Bei herkömmlichen Anordnungen ist es nicht möglich, eine entsprechende Anzahl von Schaltelementen oder Schaltertransistoren, nämlich entsprechend der Anzahl auswählbarer Zugriffsleitungseinrichtungen oder Bitleitungen, für den Spaltenmultiplexer einfach zwischen die Bitleitungen des MRAM-Arrays und den Eingang des Leseverstärkers 20 zu schalten.

Dann nämlich müsste der Lesestrom über die jeweiligen Schaltertransistoren fließen und würde zu einem unkontrollierbaren Spannungsabfall führen, der durch den Leseverstärker 20 nicht ausgeregelt werden könnte. Damit würde sich bei herkömmlichen Anordnungen am Ende der ausgewählten Bitleitung BLk keine definierte Spannung einstellen oder durch die Verstärker 20 gehalten werden können.

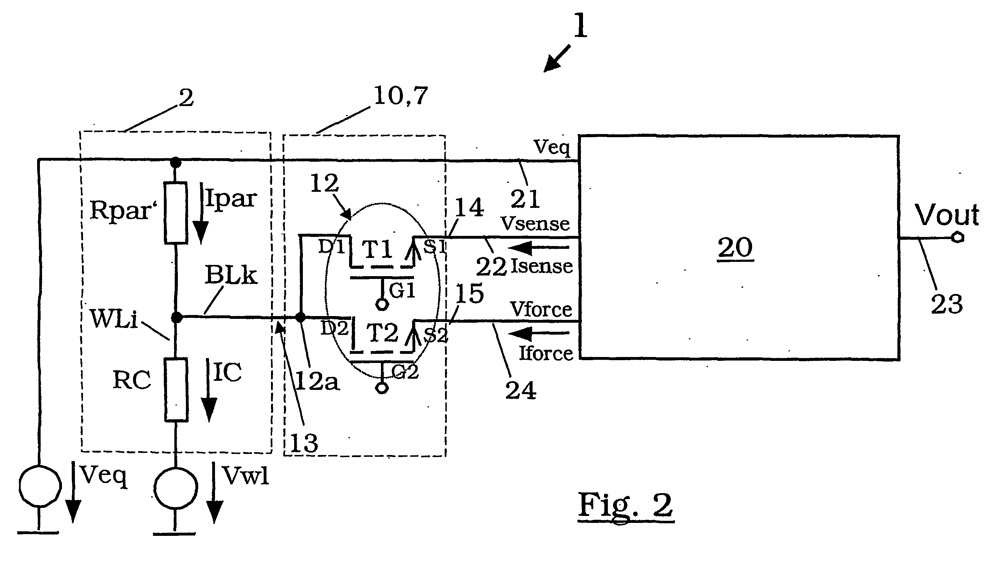

Fig. 2 zeigt anhand eines schematischen Schaltungsdiagramms eine Ausführungsform der erfindungsgemäßen Auswahleinrichtung 10 bei Verwendung in einer Halbleiterspeichereinrichtung 1.

Der Speicherbereich 2 der Halbleiterspeichereinrichtung 1 weist eine zum Auslesen selektierte Speicherzelle 3 sowie nicht selektierte Speicherzellen 3' auf. Die in Zusammenhang mit diesen selektierten und nicht selektierten Speicherzellen 3 bzw. 3' bestehenden Ohmschen Widerstände sind mit RC bzw. Rpar' bezeichnet. Die durch die selektierten und nicht selektierten Speicherzellen 3 bzw. 3' fließenden elektrischen Ströme werden als Zellstrom Ic bzw. als Parallelstrom Ipar bezeichnet.

Die angeschlossene Auswahleinrichtung 10 ist in diesem Fall als Spaltenauswahleinrichtung 7 ausgebildet. In der Fig. 2 ist ausschließlich die Schalteinrichtung 12 für die Auswahl der k-ten Bitleitung BLk dargestellt. Die entsprechenden Schaltelemente T1, T2 sind als MOSFETs ausgebildet und weisen Drainbereiche D1, D2, Sourcebereiche S1, S2, sowie Gatebereiche G1 und G2 auf.

Die ersten und zweiten Schaltelementen T1 und T2 sind vom Knoten 12a ausgehend in Parallelschaltung zueinander angeordnet. Die Drainbereiche D1 und D2 sind dabei direkt mit der k-ten Bitleitung BLk verbunden. Die Sourcebereiche S1 und S2 der Schaltelemente T1 und T2 sind mit dem Potenzialabtastanschluss 22 bzw. dem Stromeinspeiseanschluss 24 der Leseverstärkereinrichtung 20 verbunden. Über den Anschluss 21 wird die Ausgleichsspannung oder Äquipotenzialspannung Veq zugeführt. Über den Ausgang 23 der Leseverstärkereinrichtung 20 wird das ausgewertete Auslesesignal Vout bereitgestellt, durch welches der Informations- oder Speicherzustand der selektierten Speicherzelle 3 repräsentiert wird.

Die auszulesende Bitleitung BLk des Speicherbereichs 2 selbst wird hier als Serienschaltung der entsprechenden Widerstände Rpar' und Rc dargestellt. Im Vergleich zu Fig. 1 ergibt sich, dass RC den Ohmschen Widerstand der selektierten Speicherzelle 3 darstellt. Dieser liegt über die selektierte Bitleitung BLk über die Wortleitungsspannung oder Lesespannung Vwl an Masse an.

Aus der Fig. 2 ergibt sich, dass die selektierte Bitleitung BLk mit der Leseverstärkereinrichtung 20 über die Schalttransistoren T1 und T2 als erste und zweite Schaltelemente verbunden sind. Bei komplexeren Speicheranordnungen kann es notwendig sein, die Schalttransistoren T1 und T2 jeweils auch durch eine komplexere Serienschaltung mehrerer Transistoreinrichtungen auszubilden. Die Anzahl der Transistoren, welche als Serienschaltung für T1 und T2 eingesetzt werden muss, ist für die Funktionsweise des hier vorgestellten erfindungsgemäßen Prinzips aber im Wesentlichen unerheblich.

Erfindungsgemäß wirken die Schaltelemente T1 und T2 insbesondere die entsprechenden Transistoreinrichtungen T1 und T2, wie folgt: Über die Transistoreinrichtung T1 ist der Eingang, nämlich der Potenzialabtastanschluss 22, der Leseverstärkereinrichtung 20 direkt mit dem Ende der selektierten Bitleitungseinrichtung BLk verbunden. Die Leseverstärkereinrichtung 20 kann somit die an der selektierten Bitleitung BLk anliegende Spannung Vsense direkt abtasten und ermitteln. Der Ohmsche Widerstand des Schaltelements oder der Transistoreinrichtung 1 spielt wegen des relativ hohen Eingangswiderstands des Potenzialabtastwiderstandes 22 der Leseverstärkereinrichtung 20 keine Rolle, weil über das Schaltelement T1 kein nennenswerter Strom fließt, d.h., es gilt im Wesentlichen Isense = 0.

Über das zweite Schaltelement oder die zweite Transistoreinrichtung T2 regelt die Leseverstärkereinrichtung 20 über den Stromeinspeiseanschluss 24 die dort anliegende Spannung Vforce den Speisestrom oder Kompensationsstrom Icomp oder Iforce solange nach, bis über das erste Schaltelemente oder die erste Transistoreinrichtung T1 an der selektierten Bitleitung BLk die korrekte Spannung detektiert wird und eingestellt ist.

Folglich ist auch der Ohmsche Widerstand des zweiten Schaltelements T2 dazu irrelevant, weil sein Einfluss von der Leseverstärkereinrichtung 20 ausgerichtet wird. Der Kompensations- oder Speisestrom Icomp, Iforce wird von der Leseverstärkereinrichtung 20 ausgewertet und repräsentiert im Wesentlichen den ausgelesenen Programmierzustand oder Speicherzustand der selektierten Speicherzelle 3.

Die dargestellte erfindungsgemäße Schaltung ermöglicht somit die Realisierung einer Auswahleinrichtung 10, insbesondere eines Spaltenmultiplexers 7, bei welchem Spannungsabfälle über die Schaltelemente oder Schalttransistoren T1 und T2, welche durch fließende Leseströme Isense, hervorgerufen werden könnten, keine Bedeutung haben.

### Bezugszeichenliste

- 1: Halbleiterspeichereinrichtung
- 2: Speicherbereich
- 2': nicht selektierter Speicherbereich
- 3: Speicherzelle
- 3': nicht selektierte Speicherzelle
- 4: Zugriffsleitungseinrichtung/Bitleitung
- 6: Zugriffsleitungseinrichtung/Wortleitung
- 7: Spaltenmultiplexer
- 8: Zeilenmultiplexer
- 10: Auswahleinrichtung
- 12: Schalteinrichtung
- 12a: Knoten
- 13: Eingangsanschluss
- 14: Ausgangsanschluss
- 15: Ausgangsanschluss
- 16: Leitungseinrichtung
- 17: Leitungseinrichtung
- 20: Leseverstärkereinrichtung
- 21: Eingangsanschluss
- 22: Potenzialabtastanschluss
- 23: Ausgangsanschluss
- 24: Stromeinspeiseanschluss
- BLj: Bitleitungseinrichtung
- D1, D2: Drainbereich
- G1, G2: Gatebereich
- Ipar: Parallelstrom
- Ic: Zellenstrom
- Icomp: Kompensationsstrom/Speisestrom
- Iforce: Kompensationsstrom/Speisestrom
- Isense: Messstrom/Abtaststrom
- T1: erstes Schaltelement/erste Transistoreinrichtnung
- T2: zweites Schaltelement/zweite Transistoreinrichtung
- Veq: Äquipotenzialspannung/Ausgleichsspannung
- Vforce: Speisespannung/Kompensationsspannung
- Vout: Ausgabespannung
- Vsense: Abtastspannung
- Vwl: Wortleitungsspannung/Lesespannung
- WLi: Wortleitungseinrichtung

## Patentansprüche

1. Auswahleinrichtung für eine Halbleiterspeichereinrichtung,
- welche für jede auswählbare Zugriffsleitungseinrichtung (4, 6), insbesondere für jede Bitleitungseinrichtung (4), zum Zugriff auf Speicherelemente (3) des Speicherbereichs (2) der Halbleiterspeichereinrichtung (1), welche mit der jeweiligen auswählbaren Zugriffsleitungseinrichtung (4, 6) verbunden sind, jeweils eine zugeordnete Schalteinrichtung (12) aufweist,
- wobei durch die Schalteinrichtung (12) die jeweilige zugeordnete Zugriffsleitungseinrichtung (4, 6) bei Auswahl mit einer Leseverstärkereinrichtung (20) steuerbar verbindbar ist, und zwar mit einem Potenzialabtastanschluss (22) der Leseverstärkereinrichtung (20) zum Erfassen des elektrischen Potenzials der jeweiligen Zugriffsleitungseinrichtung (4, 6) und mit einem Stromeinspeiseanschluss (24) der Leseverstärkereinrichtung (20) zum Einspeisen eines Kompensationsstroms (Icomp, Isense) in die jeweilige Zugriffsleitungseinrichtung (4, 6),
**dadurch gekennzeichnet,**
- **dass** jede Schalteinrichtung (12) jeweils ein erstes und ein zweites Schaltelement (T1, T2) aufweist,
- **dass** im Betrieb durch das erste Schaltelement (T1) die zugeordnete Zugriffsleitungseinrichtung (4, 6) mit dem Potenzialabtastanschluss (22) der Leseverstärkereinrichtung (20) verbindbar ist und
- **dass** in Betrieb durch das zweite Schaltelement (T2) die zugeordnete Zugriffsleitungseinrichtung (4, 6) mit dem Stromeinspeiseanschluss (24) der Leseverstärkereinrichtung (20) verbindbar ist.

2. Auswahleinrichtung nach Anspruch 1,
**dadurch gekennzeichnet,**
**dass** die Schaltelemente (T1, T2) jeweils parallel zueinander geschaltet sind.

3. Auswahleinrichtung nach einem der vorangehenden Ansprüche,
**dadurch gekennzeichnet,**
**dass** durch die Schaltelemente (T1, T2) jeweils zwei Schaltzustände ausbildbar sind, insbesondere ein durchgeschalteter oder kontaktierender und ein nicht durchgeschalteter oder trennender Schaltzustand.

4. Auswahleinrichtung nach einem der vorangehenden Ansprüche,
**dadurch gekennzeichnet,**
**dass** durch das erste Schaltelement (T1) im ersten, durchgeschalteten oder kontaktierenden Schaltzustand ein vergleichsweise niederohmiger Kontakt herstellbar ist, insbesondere in Bezug auf den Potenzialabstastanschluss (22) der Leseverstärkereinrichtung (20).

5. Auswahleinrichtung nach einem der vorangehenden Ansprüche,
**dadurch gekennzeichnet,**
**dass** die Schaltelemente (T1, T2) als Transistoreinrichtungen ausgebildet sind, insbesondere als MOSFETs.

6. Auswahleinrichtung nach Anspruch 5,
**dadurch gekennzeichnet,**
**dass** jeweils Drainbereiche (D1, D2) der Transistoreinrichtung (T1, T2) mit der jeweils angeordneten Zugriffsleitungseinrichtung (4, 6) verbunden ausgebildet sind.

7. Auswahleinrichtung nach einem der Ansprüche 5 oder 6,
**dadurch gekennzeichnet,**
**dass** jeweils Sourcebereiche (S1, S2) der Transistoreinrichtungen (T1, T2) mit dem jeweiligen Potenzialanschluss (22) bzw. dem jeweiligen Stromeinspeiseanschluss (22) der zugeordneten Leseverstärkereinrichtung (20) verbunden ausgebildet sind.

8. Auswahleinrichtung nach einem der vorangehenden Ansprüche,
**dadurch gekennzeichnet,**
**dass** die Mehrzahl der Ausgangsanschlüsse (14), insbesondere die Sourcebereiche (S1, S2) der ersten und zweiten Schaltelemente (T1, T2), jeweils mit einer gemeinsamen Leitungseinrichtung (16, 17) und über diese mit einer einzigen gemeinsamen Leseverstärkereinrichtung (20) verbunden ist.

## Claims

1. Selection device for a semiconductor memory device,
- which has, for each selectable access line device (4, 6), particularly for each bit line device (4), for accessing storage elements (3) in the memory area (2) of the semiconductor memory device (1) which are connected to the respective selectable access line device (4, 6), a respective associated switching device (12),
- where the switching device (12) can controllably connect the respective associated access line device (4, 6), upon selection, to a sense-amplifier device (20), specifically to a potential-sensing connection (22) on the sense-amplifier device (20) for detecting the electrical potential on the respective access line device (4, 6) and to a current-supply connection (24) on the sense-amplifier device (20) for supplying a compensating current (Icomp, Isense) to the respective access line device (4, 6,),
**characterized**
- **in that** each switching device (12) has a first and a second switching element (T1, T2), respectively,
- **in that**, during operation, the first switching element (T1) can connect the associated access line device (4, 6) to the potential-sensing connection (22) on the sense-amplifier device (20), and
- **in that**, during operation, the second switching element (T2) can connect the associated access line device (4, 6) to the current-supply connection (24) on the sense-amplifier device (20).

2. Selection device according to Claim 1,
**characterized**
**in that** the switching elements (T1, T2) are respectively connected in parallel with one another.

3. Selection device according to one of the preceding claims,
**characterized**
**in that** the switching elements (T1, T2) can each produce two switching states, particularly a connected or contact-making switching state and a disconnected or isolating switching state.

4. Selection device according to one of the preceding claims,
**characterized**
**in that**, in the first, connected or contact-making switching state, the first switching element (T1) can make comparatively low-impedance contact, particularly for the potential-sensing connection (22) on the sense-amplifier device (20).

5. Selection device according to one of the preceding claims,
**characterized**
**in that** the switching elements (T1, T2) are in the form of transistor devices, particularly in the form of MOSFETs.

6. Selection device according to Claim 5,
**characterized**
**in that** respective drain regions (D1, D2) of the transistor device (T1, T2) are in a form connected to the respectively arranged access line device (4, 6).

7. Selection device according to one of Claims 5 or 6,
**characterized**
**in that** respective source regions (S1, S2) of the transistor devices (T1, T2) are in a form connected to the respective potential connection (22) or to the respective current-supply connection (22) on the associated sense-amplifier device (20).

8. Selection device according to one of the preceding claims,
**characterized**
**in that** the plurality of output connections (14), particularly the source regions (S1, S2) on the first and second switching elements (T1, T2), are respectively connected to a common line device (16, 17) and, via the latter, to a single common sense-amplifier device (20).

## Revendications

1. Dispositif de sélection pour un dispositif de mémoire à semiconducteur,
- qui a pour chaque dispositif (4, 6) de ligne d'accès, notamment pour chaque dispositif (4) de ligne de bit, pour l'accès à des éléments (3) de mémoire de la partie (2) de mémoire du dispositif (1) de mémoire à semiconducteur qui sont reliés au dispositif (4, 6) de ligne d'accès pouvant être sélectionné respectivement, respectivement un dispositif (12) de commutation associé,
- dans lequel, par le dispositif (12) de commutation, le dispositif (4, 6) de ligne d'accès associé respectivement peut, lors de la sélection, être relié de manière à pouvoir être commandé à un dispositif (20) d'amplification de lecture et cela par une borne (22) de détection de potentiel du dispositif (20) amplificateur de lecture pour la détection du potentiel électrique du dispositif (4, 6) de ligne d'accès respectif et à une borne (24) d'alimentation en courant du dispositif (20) amplificateur de lecture pour l'injection d'un courant (lcomp, Isense) de compensation dans le dispositif (4, 6) de ligne d'accès respectif,
**caractérisé**
- **en ce que** chaque dispositif (12) de commutation a respectivement un premier et un deuxième élément (T1, T2) de commutation,
- **en ce que**, en fonctionnement, le dispositif (4, 6) de ligne d'accès associé peut, par le premier élément (T1) de commutation, être relié à la borne (22) de détection du potentiel du dispositif (20) amplificateur de lecture et
- **en ce que**, en fonctionnement, le dispositif (4, 6) de ligne d'accès associé peut, par le deuxième élément (T2) de commutation, être relié à la borne (24) d'alimentation en courant du dispositif (20) amplificateur de lecture.

2. Dispositif de sélection suivant la revendication 1,
**caractérisé**
**en ce que** les éléments (T1, T2) de commutation sont montés respectivement en parallèle l'un avec l'autre.

3. Dispositif de sélection suivant l'une des revendications précédentes,
**caractérisé**
**en ce que** par les éléments (T1, T2) de commutation respectivement deux états de commutation peuvent être constitués, notamment un état de connexion ou de contact et un état de non connexion ou de coupure.

4. Dispositif de sélection suivant l'une des revendications précédentes,
**caractérisé**
**en ce que** par le premier élément (T1) de connexion, il peut être ménagé, dans le premier état de commutation de connexion ou de contact, un contact à valeur ohmique relativement petite, notamment par rapport à la borne (22) de détection du potentiel du dispositif (20) amplificateur de lecture.

5. Dispositif de sélection suivant l'une des revendications précédentes,
**caractérisé**
**en ce que** les éléments (T1, T2) de commutation sont constitués sous la forme de dispositifs à transistor, notamment de MOSFET.

6. Dispositif de sélection suivant la revendication 5,
**caractérisé**
**en ce que** respectivement des zones (D1, D2) de drain du dispositif (T1, T2) à transistor sont constitués en étant reliés au dispositif (4, 6) de ligne d'accès respectif.

7. Dispositif de sélection suivant l'une des revendications 5 ou 6,
**caractérisé**
**en ce que** respectivement des zones (S1, S2) de source des dispositifs (T1, T2) à transistor sont constituées en étant reliées à la borne (22) respective de potentiel ou à la borne (22) respective d'alimentation en courant du dispositif (20) amplificateur de lecture associé.

8. Dispositif de sélection suivant l'une des revendications précédentes,
**caractérisé**
**en ce que** la multiplicité des bornes (14) de sortie, notamment les zones (S1, S2) de source des premier et deuxième éléments (T1, T2) de commutation, sont reliées respectivement à un dispositif (16, 17) de ligne commun et par celui-ci à un seul dispositif (20) amplificateur de lecture commun.
